# EUROPÄISCHE PATENTSCHRIFT

(11) **EP 3 153 938 B1**
(45) Veröffentlichungstag und Bekanntmachung des Hinweises auf die Patenterteilung: **26.09.2018**
(21) Anmeldenummer: 15188638.9
(22) Anmeldetag: 06.10.2015
(51) Int. Cl.: G05B 19/00, G08C 17/02

(54) **MESSANORDNUNG**
MEASURING APPARATUS
DISPOSITIF DE MESURE

(43) Veröffentlichungstag der Anmeldung: 12.04.2017
(73) Patentinhaber: VEGA Grieshaber KG, 77709 Wolfach (DE)
(72) Erfinder: Allgaier, Volker, 77761 Haslach i. K. (DE); Wöhrle, Siegbert, 77761 Schiltach (DE)
(74) Vertreter: Westphal, Mussgnug & Partner Patentanwälte mbB

(56) Entgegenhaltungen:
- EP-A1- 1 293 853
- EP-A1- 1 591 977
- DE-A1-102013 103 454
- US-A1- 2008 280 568

## Beschreibung

Die vorliegende Erfindung betrifft eine Messanordnung mit einem Zweileiterfeldgerät, ein Zweileiterfeldgerät sowie ein Verfahren zum Betreiben eines Zweileiterfeldgerätes.

In der Prozessautomatisierungstechnik werden vielfach Feldgeräte eingesetzt, die zur Erfassung und/oder Beeinflussung von Prozessvariablen dienen. Beispiele für derartige Feldgeräte sind Füllstandmessgeräte, Grenzstandmessgeräte und Druckmessgeräte mit Sensoren, die die entsprechenden Prozessvariablen Füllstand, Grenzstand oder Druck erfassen. Häufig sind solche Feldgeräte mit übergeordneten Einheiten, zum Beispiel Leitsystemen oder Steuereinheiten, verbunden. Diese übergeordneten Einheiten dienen zur Prozesssteuerung, Prozessvisualisierung und/oder Prozessüberwachung.

Solche Feldgeräte sind zum Beispiel aus EP 1 591 977 A1, US 2008/0280568 A1, EP 1 293 853 A1, und DE 10 2013 103 454 A1 bekannt.

Die Energie- und/oder Signalübertragung zwischen Feldgerät und übergeordneten Einheiten erfolgt häufig nach dem bekannten 4 mA bis 20 mA Standard, bei dem eine 4 mA bis 20 mA Stromschleife beziehungsweise eine Zweidrahtleitung zwischen dem Feldgerät und der übergeordneten Einheit ausgebildet ist. Zusätzlich zu der analogen Übertragung von Signalen besteht die Möglichkeit, dass die Messgeräte gemäß verschiedenen anderen Protokollen, insbesondere digitalen Protokollen, weitere Informationen an die übergeordnete Einheit übermitteln oder von dieser empfangen. Beispielhaft seien hierfür das HART-Protokoll oder das Profibus-PA-Protokoll genannt.

Die Energieversorgung dieser Feldgeräte erfolgt ebenfalls über das 4 mA bis 20 mA Stromsignal, sodass neben der Zweidrahtleitung keine zusätzliche Versorgungsleitung notwendig ist. Um den Verdrahtungs- und Installationsaufwand sowie die Sicherheitsmaßnahmen, beispielsweise beim Einsatz in explosionsgeschützten Bereichen, so gering wie möglich zu halten, ist es auch nicht gewünscht, zusätzliche Stromversorgungsleitungen vorzusehen.

Aus dem Stand der Technik sind beispielsweise Bedieneinheiten bekannt, die zur Kommunikation mit dem Feldgerät physikalisch an die 4 mA bis 20 mA Stromschleife angeschlossen werden, um so die Bedienung des Feldgerätes über die 4 mA bis 20 mA Stromschleife mittels des HART-Protokolls zu ermöglichen. Derartige Bedieneinheiten weisen den Nachteil auf, dass sie wie bereits erwähnt, physikalisch an die 4 mA bis 20 mA Stromschleife angeschlossen werden müssen. Hierzu muss die Zweidrahtleitung derartig modifiziert, beispielsweise abisoliert und/oder durchtrennt, werden, sodass die Bedieneinheit angeschlossen werden kann. Dies stellt einen relativ hohen Aufwand dar und ist vor Ort nicht immer ohne Weiteres zu bewerkstelligen. Alternativ kann ein Bediengerät auch an einem vorhandenen HART-Widerstand angeschlossen werden, dann ist kein Auftrennen der Leitung notwendig.

Aus dem Stand der Technik ist es ferner bekannt, Funkmodule zur leichteren Bedienung von Feldgeräten zu verwenden. Es sind Lösungen bekannt, bei denen die Feldgeräte integrierte Funkmodule aufweisen, Funkmodule nachgerüstet werden oder in einem Messumformerspeisegerät, einer Einrichtung zur Energieversorgung der Feldgeräte, angeordnet sind. Insbesondere bei den Varianten mit integriertem Funkmodul oder mit einem Funkmodul, das beispielsweise bei modular aufgebauten Feldgeräten nachgerüstet werden soll, besteht im Stand der Technik das Problem, dass eine Energieversorgung über die 4 mA bis 20 mA Stromschleife nur äußerst geringe Sendeleistungen der Funkmodule zulässt oder der Betrieb eines Funkmodules aufgrund der nur begrenz zur Verfügung stehenden Energie nur mit geringer Sendeleistung möglich ist oder die über die Stromschleife zuführbare Energie nicht ausreicht, um das Funkmodul mit ausreichend Energie zu versorgen, sodass ein Betrieb nicht oder nur mit starken Limitierungen möglich ist.

Im Stand der Technik sind hierfür Lösungen bekannt, bei denen das Funkmodul mit einer eigenen Energieversorgung versehen ist oder zusätzliche Energiequellen, wie Batterien, Energy-Harvester, oder dergleichen zum Betrieb des Funkmodules in dem Feldgerät vorgesehen sind. Beide vorgenannten Lösungen weisen einen erhöhten Installations- und Wartungsaufwand auf, sodass diese als nachteilig empfunden werden.

Es ist die Aufgabe der vorliegenden Erfindung, eine Messanordnung mit einem Zweileiterfeldgerät, ein Zweileiterfeldgerät sowie ein Verfahren zum Betreiben eines Zweileiterfeldgerätes zur Verfügung zu stellen, die die aus dem Stand der Technik bekannten Nachteile nicht aufweist und insbesondere auf eine zusätzliche Energieversorgung, insbesondere auf eine zusätzliche kabelgebundene oder teilweise oder vollständige batteriebasierte Energieversorgung, verzichten kann.

Diese Aufgabe wird durch eine Messanordnung mit den Merkmalen des Patentanspruchs 8, ein Zweileiterfeldgerät mit den Merkmalen des Patentanspruchs 1 sowie ein Verfahren zum Betreiben eines Zweileiterfeldgerätes mit den Merkmalen des Patentanspruchs 6 gelöst.

Eine erfindungsgemäße Messanordnung weist ein Zweileiterfeldgerät mit einer Steuereinheit und einem Sensor, auf, wobei das Feldgerät über eine Zweidrahtleitung an eine übergeordnete Einheit angebunden ist und Signale von dem Feldgerät zu der übergeordneten Einheit zumindest als von dem Feldgerät eingeprägter Strom in einem vorgegebenen Bereich an die übergeordnete Einheit übermittelt werden, wobei ein Fehlerstrom unterhalb des vorgegebenen Bereiches einen Fehler signalisiert und ein Wartungsstrom oberhalb des vorgegebenen Bereiches einen Wartungsmodus des Feldgeräts signalisiert, in dem kein Fehler vorliegt und die übergeordnete Einheit nicht mit einer Störung reagiert. Erfindungsgemäß weist das Zweileiterfeldgerät ein Funkmodul auf und das Feldgerät ist so ausgebildet, dass der Wartungsstrom das Funkmodul in einem Funkbetrieb speist. Die Steuereinheit ist dabei so ausgebildet, dass sie während einer aktiven Funkverbindung des Funkmodules, insbesondere einer aktiven Funkverbindung in einem Modus für eine erhöhte Datenrate, den Wartungsstrom und damit den Wartungsmodus aktiviert.

Bei dem aus dem Stand der Technik bekannten 4 mA bis 20 mA Protokoll werden Stromwerte außerhalb des vorgegebenen Bereiches von 4 mA bis 20 mA, in den ein Messstrom übertragen wird, typischerweise als Fehler erkannt und daher dazu verwendet, Fehlerzustände des Feldgerätes an die übergeordnete Einheit, beispielweise das Leitsystem oder die Steuereinheit, zu übermitteln. Alternativ besteht aber die Möglichkeit, einen Fehler nur mit einem eingeprägten Strom unterhalb des vorgegebenen Bereiches zu signalisieren und mit einem Strom oberhalb des vorgegebenen Bereiches der übergeordneten Einheit mitzuteilen, dass sich das Feldgerät in einem Wartungsmodus befindet. Auf diese Weise wird erreicht, dass die übergeordnete Einheit nicht mit einer Störung reagiert, sondern das Ende des Wartungsmodus abwartet und dann wieder in einen regulären Messbetrieb übergeht. Bei dem bekannten 4 mA bis 20 mA Protokoll kann damit erreicht werden, dass im Wartungsmodus eine Stromstärke von 22 mA auf der Zweidrahtleitung eingeprägt wird und damit zur Versorgung des Funkmodules in einem Funkbetrieb zur Verfügung steht. Auf diese Weise kann erreicht werden, dass das Funkmodul in bestimmten Situationen mit einer höheren Leistung betrieben und damit eine vergrößerte Reichweite oder ein höherer Datendurchsatz erreicht werden kann. Da während der Einprägung des Wartungsstromes keine [analoge] Datenübermittlung über die Zweidrahtleitung erfolgt, funktioniert diese zu diesem Zeitpunkt nicht mehr als Mess- und Steuergerät, sondern als reine Energieversorgung beziehungsweise Spannungsquelle.

Sind beispielsweise die Steuereinheit und das Funkmodul so miteinander verbunden, dass der Steuereinheit eine aktive Funkverbindung des Funkmodules insbesondere eine Funkverbindung mit Bedarf einer erhöhten Datenrate signalisiert wird, kann diese im Bedarfsfall den Wartungsstrom auf der Zweidrahtleitung einprägen, sodass für die Funkverbindung ausreichend Energie zur Verfügung steht.

Für typische Anwendungen beträgt der vorgegebene Bereich für den Messstrom 4 mA bis 20 mA, der Fehlerstrom beträgt weniger als 4 mA, insbesondere 3,6 mA, und der Wartungsstrom mehr als 20 mA, insbesondere 22 mA.

Um möglichst viel Energie für das Funkmodul zur Verfügung zu haben, werden im Wartungsmodus keine analogen Signale an die übergeordnete Einheit übermittelt, sodass diese als reine Energiequelle fungiert. Es können aber weiterhin digitale Signale bspw. über das HART-Protokoll übermittelt werden. Idealerweise ist sowohl der Sensor als auch das Funkmodul mit der Steuereinheit des Feldgerätes verbunden, sodass diese als zentrale Einheit sämtliche Steuerungsfunktionen übernehmen kann. Insbesondere wird auf diese Weise ermöglicht, dass die Steuereinheit beispielsweise Messwerte des Sensors an das Funkmodul zur Weiterleitung an einen Empfänger übergibt oder bei Funkübertragungen, die viel Energie benötigen, sogar der Sensor zeitweilig deaktiviert wird.

Ferner kann die Steuereinheit auf diese Weise nach Beendigung einer Funkübertragung das analoge Messsignal wieder auf die Zweidrahtleitung einprägen.

Ein erfindungsgemäßes Zweileiterfeldgerät weist eine Steuereinheit, einen Sensor und ein Funkmodul auf und ist zur Anbindung an eine übergeordnete Einheit über eine Zweidrahtleitung ausgebildet, wobei das Feldgerät ferner derart ausgebildet ist, dass es Signale zu der übergeordneten Einheit zumindest als eingeprägter Strom in einem vorgegebenen Bereich an die übergeordnete Einheit übermittelt und sich dadurch auszeichnet, dass ein Fehlerstrom unterhalb des vorgegebenen Bereiches einen Fehler signalisiert und ein Wartungsstrom oberhalb des vorgegebenen Bereiches einen Wartungsmodus des Feldgeräts signalisiert, in dem kein Fehler vorliegt und die übergeordnete Einheit nicht mit einer Störung reagiert, und das Feldgerät so ausgebildet ist, dass der Wartungsstrom das Funkmodul im Funkbetrieb speist.

Ein erfindungsgemäßes Verfahren zum Betreiben eines Zweileiterfeldgerätes mit einer Steuereinheit und einem Sensor, , bei dem das Feldgerät über eine Zweidrahtleitung an eine übergeordnete Einheit anbindbar ist und Signale von dem Feldgerät zu der übergeordneten Einheit zumindest als eingeprägter Strom in einem vorgegebenen Bereich an die übergeordnete Einheit übermittelt werden, wobei durch einen Fehlerstrom unterhalb des vorgegebenen Bereiches ein Fehler signalisiert und durch einen Wartungsstrom oberhalb des vorgegebenen Bereiches ein Wartungsmodus signalisiert wird, zeichnet sich dadurch aus, dass das Zweileiterfeldgerät ein Funkmodul aufweist und der Wartungsstrom bei einer aktiven Funkverbindung das Funkmodul speist. Dabei wird der Wartungsmodus während einer aktiven Funkverbindung des Funkmodules durch die Steuereinheit aktiviert.

Vorteilhafte Weiterbildungen sind Gegenstand abhängiger Ansprüche.

Die vorliegende Erfindung wird nachfolgend unter Bezugnahme auf die beiliegende Figur eingehend erläutert. Es zeigt:

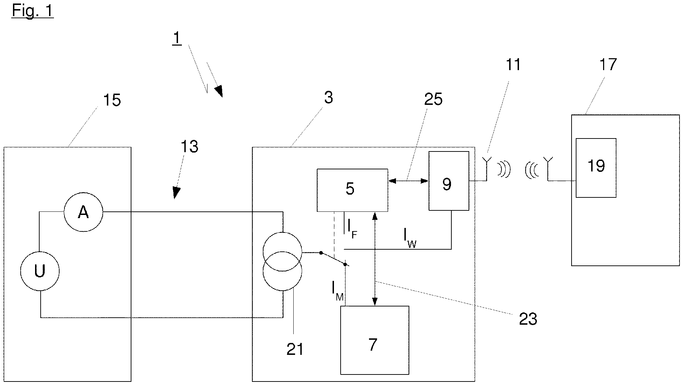

- Fig. 1: ein Blockschaltbild eines Ausführungsbeispieles einer erfindungsgemäßen Messanordnung.

Figur 1 zeigt ein Blockschaltbild einer erfindungsgemäßen Messanordnung 1 mit einem Zweileiterfeldgerät 3, das über eine Zweidrahtleitung 13 mit einer übergeordneten Einheit 15, die vorliegend als speicherprogrammierbare Steuerung (SPS) ausgebildet ist, verbunden ist. Das Zweileiterfeldgerät 3 kommuniziert mit der übergeordneten Einheit 15 nach dem 4 mA bis 20 mA Protokoll. Bei diesem 4 mA bis 20 mA Protokoll wird ein Messsignal eines in dem Feldgerät 3 enthaltenen Sensors 7 in einen zu dem Messsignal proportionalen Strom zwischen 4 mA und 20 mA umgesetzt und auf die Zweidrahtleitung 13 aufgeprägt. Ströme außerhalb des vorgegebenen Bereiches von 4 mA bis 20 mA repräsentieren einen Zustand außerhalb eines Messmodus und werden von der übergeordneten Einheit 15 je nach Programmierung als Fehler oder als Signal für einen Wartungsmodus des Feldgerätes 3 interpretiert. Über die Zweidrahtleitung 13 erfolgt sowohl die Übermittlung von Messsignalen als auch eine Energieversorgung des Zweileiterfeldgerätes 3. Das Feldgerät 3 weist im Wesentlichen einen Sensor 7 zur Erfassung einer Messgröße, beispielsweise eines Füllstandes, auf, der mit einer Steuereinheit 5 über eine Verbindung 23 verbunden ist. Das Feldgerät 3 kann im vorliegenden Ausführungsbeispiel im Wesentlichen drei unterschiedliche Zustände einnehmen, wobei in einem Messmodus ein Messstrom I_{M}, der ein Messsignal des Sensors 7 repräsentiert, über eine Stromsenke 21 auf die Zweidrahtleitung 13 eingeprägt wird. Der Messstrom I_{M} ist proportional zu dem Messsignal des Sensors 7 und kann entweder direkt von dem Sensor 7 oder über die Steuereinheit 5 auf die Zweidrahtleitung 13 gegeben werden.

Im vorliegenden Ausführungsbeispiel sind das Feldgerät 3 und die übergeordnete Einheit 15 derart aufeinander abgestimmt, dass Ströme oberhalb des vereinbarten Bereiches von 4 mA bis 20 mA als Signal für einen Wartungsmodus und Ströme unterhalb des vereinbarten Bereiches als Signal für einen Fehler gelten.

In einem zweiten Zustand ist ein in dem Feldgerät 3 angeordnetes Funkmodul 9 aktiviert und wird über die Zweidrahtleitung 13 mit Energie versorgt. Um eine Sendeleistung des Funkmodules 9 zu erhöhen oder mit dem Funkmodul 9 eine höhere Datenrate verwirklichen zu können, wird in diesem zweiten Zustand ein sogenannter Wartungsstrom I_{W} auf die Zweidrahtleitung 13 eingeprägt. Der Wartungsstrom I_{w} liegt oberhalb des vorgegebenen Bereiches für den Messstrom I_{M} und signalisiert der übergeordneten Einheit 15 damit, dass sich das Feldgerät 3 in einem Wartungsmodus befindet, was gleichzeitig bedeutet, dass kein Fehler vorliegt und die übergeordnete Einheit 15 nicht mit einer Störung auf dieses Signal reagiert.

Durch Aufprägen des Wartungsstromes I_{w} wird der übergeordneten Einheit 15 signalisiert, dass sich das Feldgerät in einem Wartungsmodus befindet und daher keine Messwerte über die Zweidrahtleitung 13 übermittelt werden. Da der Wartungsstrom I_{w} oberhalb des Messbereiches von 4 mA bis 20 mA, vorliegend bei 22 mA, liegt, steht für den Betrieb des Funkmodules 9 mehr Leistung zur Verfügung, die eine größere Reichweite oder einen höheren Datendurchsatz ermöglicht. Um eine Aktivierung des Funkmodules 9 zu signalisieren, ist diese über eine Verbindung 25 mit der Steuereinheit 5 verbunden. Auf diese Weise kann die Steuereinheit 5 von dem Funkmodul 9 unmittelbar darüber in Kenntnis gesetzt werden, dass eine Funkverbindung aktiv und daher ein erhöhter Energiebedarf vorhanden ist.

In einem dritten Zustand, in dem eine Störung des Feldgerätes 3 vorliegt, wird ein Fehlerstrom I_{F} von vorliegend 3,6 mA, das heißt unterhalb des Messbereiches von 4 mA bis 20 mA auf der Zweidrahtleitung 13 eingestellt, wodurch die übergeordnete Einheit 15 vom Vorliegen der Störung in Kenntnis gesetzt wird. Von der übergeordneten Einheit 15 kann dementsprechend eine Fehlermeldung ausgegeben werden.

Dem Funkmodul 9 ist eine Antenne 11 nachgeschaltet, die über eine Funkverbindung mit einem zweiten Funkmodul 19 eines Mobilgerätes 17 kommuniziert. Das Mobilgerät kann im vorliegenden Ausführungsbeispiel damit zur Konfiguration des Feldgerätes 3 und/oder zur Anzeige von Messwerten vor Ort herangezogen werden. Auf diese Weise wird es beispielsweise möglich, dass das Feldgerät 3 ohne eigenes Display ausgeführt sein kann und dennoch ohne Herstellung einer physikalischen Verbindung mit dem Feldgerät 3 eine vor Ort Anzeige von Messwerten oder eine Kalibrierung oder sonstige Einstellungen des Feldgerätes 3 vorgenommen werden.

### Bezugszeichenliste

- 1: Messanordnung
- 3: Feldgerät
- 5: Steuereinheit
- 7: Sensor
- 9: Funkmodul

- 11: Antenne
- 13: Zweidrahtleitung
- 15: Übergeordnete Einheit
- 17: Mobiles Gerät
- 19: Mobilgeräteseitiges Funkmodul

- 21: Stromsenke
- 23: Verbindung
- 25: Verbindung

- I_{M}: Messstrom
- I_{F}: Fehlerstrom
- I_{w}: Wartungsstrom

## Patentansprüche

1. Zweileiterfeldgerät (3) mit einer Steuereinheit (5) und einem Sensor (7), zur Anbindung über eine Zweidrahtleitung (13) an eine übergeordnete Einheit (15),
wobei das Feldgerät (1) derart ausgebildet ist, dass Signale zu der übergeordneten Einheit (15) zumindest als eingeprägter Strom (I_{M}) in einem vorgegebenen Bereich an die übergeordnete Einheit (15) übermittelt werden, wobei ein Fehlerstrom (I_{F}) unterhalb des vorgegebenen Bereichs einen Fehler signalisiert und ein Wartungsstrom (I_{w}) oberhalb des vorgegebenen Bereichs einen Wartungsmodus des Feldgeräts (3) signalisiert, in dem kein Fehler vorliegt und die übergeordnete Einheit (15) nicht mit einer Störung reagiert,
**dadurch gekennzeichnet, dass**
das Zweileitergerät ein Funkmodul (9) aufweist und das Feldgerät (3) so ausgebildet ist, dass der Wartungsstrom (I_{w}) das Funkmodul (9) im Funkbetrieb speist, wobei die Steuereinheit (5) derart ausgebildet ist, dass sie während einer aktiven Funkverbindung des Funkmoduls (9), insbesondere einer aktiven Funkverbindung mit Bedarf einer erhöhten Datenrate, den Wartungsmodus aktiviert.

2. Zweileiterfeldgerät (3) gemäß Anspruch 1,
**dadurch gekennzeichnet, dass**
die Steuereinheit (5) und das Funkmodul (9) derart verbunden sind, dass der Steuereinheit eine aktive Funkverbindung des Funkmoduls (9), insbesondere einer aktiven Funkverbindung mit Bedarf einer erhöhten Datenrate, signalisiert wird.

3. Zweileiterfeldgerät (3) gemäß einem der Ansprüche 1 bis 2,
**dadurch gekennzeichnet, dass**
der Messstrom (I_{M}) in dem vorgegebene Bereich zwischen 4 mA und 20 mA beträgt, der Fehlerstrom weniger als 4 mA, insbesondere 3,6 mA, und der Wartungsstrom mehr als 20 mA, insbesondere 22 mA beträgt.

4. Zweileiterfeldgerät (3) gemäß einem der Ansprüche 1 bis 3,
**dadurch gekennzeichnet, dass**
im Wartungsmodus keine analogen Signale an die übergeordnete Einheit (15) übermittelt werden und diese als reine Energiequelle fungiert.

5. Zweileiterfeldgerät (3) gemäß einem der Ansprüche 1 bis 4,
**dadurch gekennzeichnet, dass**
der Sensor (7) und das Funkmodul (9) mit der Steuereinheit (5) verbunden sind.

6. Verfahren zum Betreiben eines Zweileiterfeldgerätes (3) mit einer Steuereinheit (5) und einem Sensor (7),
wobei das Feldgerät (3) über eine Zweidrahtleitung (13) an eine übergeordnete Einheit (15) anbindbar ist und Signale von dem Feldgerät (3) zu der übergeordneten Einheit (15) zumindest als eingeprägter Strom (I_{M}) in einem vorgegebenen Bereich an die übergeordnete Einheit (15) übermittelt werden, wobei durch einen Fehlerstrom (I_{F}) unterhalb des vorgegebenen Bereichs ein Fehler signalisiert und durch einen Wartungsstrom (I_{w}) oberhalb des vorgegebenen Bereichs einen Wartungsmodus signalisiert wird, in dem kein Fehler vorliegt,
**dadurch gekennzeichnet, dass**
das Zweileitergerät ein Funkmodul (9) aufweist und der Wartungsstrom (I_{w}) bei einer aktiven Funkverbindung das Funkmodul (9) speist, wobei während einer aktiven Funkverbindung des Funkmoduls (9), der Wartungsmodus durch die Steuereinheit (5) aktiviert wird.

7. Verfahren nach Anspruch 7,
**dadurch gekennzeichnet, dass**
nach Abschluss einer aktiven Funkverbindung des Funkmoduls (9) der Wartungsstrom (I_{w}) deaktiviert wird und je nach Zustand des Feldgerätes (3) ein Fehlerstrom (I_{F}) oder ein Messstrom (I_{M}) aktiviert wird.

8. Messanordnung (1) mit
- einem Zweileiterfeldgerät (3) der Ansprüche 1 bis 5 und,
- einer übergeordneten Einheit (15), an die das Feldgerät (3) über eine Zweidrahtleitung (13) angebunden ist.

## Claims

1. Two-wire field device (3) having a control unit (5) and a sensor (7), for connecting via a two-wire line (13) to a superordinate unit (15), wherein the field device (1) is designed in such a manner that signals are transmitted to the superordinate unit (15) at least as a current (I_{M}) injected in a predetermined range to the superordinate unit (15), wherein an error current (I_{F}) below the predetermined range signals an error and a maintenance current (I_{w}) above the predetermined range signals a maintenance mode of the field device (3), in which no error is present and the superordinate unit (15) does not react with a malfunction, **characterized in that** the two-wire device has a radio module (9) and the field device (3) is designed in such a manner that the maintenance current (I_{w}) feeds the radio module (9) in radio operation, wherein the control unit (5) is designed in such a manner that during an active radio connection of the radio module (9), particularly an active radio connection requiring an increased data rate, it activates the maintenance mode.

2. Two-wire field device (3) in accordance with claim 1, **characterized in that** the control unit (5) and the radio module (9) are connected in such a manner that an active radio connection of the radio module (9), particularly an active radio communication requiring an increased data rate, is signaled to the control unit.

3. Two-wire field device (3) in accordance with either of claims 1 or 2, **characterized in that** the measuring current (I_{M}) is in the predetermined range of between 4 mA and 20 mA, the error current is lower than 4 mA, particularly 3.6 mA, and the maintenance current is greater than 20 mA, particularly 22 mA.

4. Two-wire field device (3) in accordance with any one of claims 1 to 3, **characterized in that** in the maintenance mode no analogue signals are transmitted to the superordinate unit (15) and this acts as a pure energy source.

5. Two-wire field device (3) in accordance with any one of claims 1 to 4, **characterized in that** the sensor (7) and the radio module (9) are connected to the control unit (5).

6. Method for operating a two-wire field device (3) having a control unit (5) and a sensor (7), wherein the field device (3) can be connected via a two-wire line (13) to a superordinate unit (15) and signals are transmitted from the field device (3) to the superordinate unit (15) at least as a current (I_{M}) injected in a predetermined range to the superordinate unit (15), wherein by means of an error current (I_{F}) below the predetermined range an error is signaled and by means of a maintenance current (I_{w}) above the predetermined range a maintenance mode, in which no error is present, is signaled, **characterized in that** the two-wire device has a radio module (9) and the maintenance current (I_{w}) feeds the radio module (9) in an active radio connection, wherein during an active radio connection of the radio module (9), the maintenance mode is activated by the control unit (5).

7. Method according to claim 7, **characterized in that** after termination of an active radio connection of the radio module (9), the maintenance current (I_{w}) is deactivated and depending upon the condition of the field device (3) an error current (I_{F}) or a measuring current (I_{M}) is activated.

8. Measuring arrangement (1) having
- a two-wire field device (3) of claims 1 to 5 and
- a superordinate unit (15), to which the field device (3) is connected via a two-wire line (13).

## Revendications

1. Appareil de chantier à deux conducteurs (3) comprenant une unité de commande (5) et un capteur (7) destiné à être relié par l'intermédiaire d'une conduite à deux brins (13) à une unité prioritaire (15), l'appareil de chantier (1) étant réalisé de sorte que des signaux vers l'unité prioritaire (15) soient transmis à celle-ci au moins sous la forme d'un courant indépendant de la charge (I_{M}) situé dans une plage prédéfinie, un courant de défaut (I_{F}) situé au-dessous de la plage prédéfinie signalant un défaut, et un courant de veille (I_{w}) situé au-dessus de la plage prédéfinie signalant un mode de veille de l'appareil de chantier (3) dans lequel il n'y a pas de défaut et l'unité prioritaire (15) n'agit pas avec un dysfonctionnement,
**caractérisé en ce que**
l'appareil de chantier à deux conducteurs (3) comporte un module radio (9) et est réalisé de sorte que le courant de veille (I_{w}) alimente le module radio (9) dans un mode de fonctionnement radio, l'unité de commande (5) étant réalisée de façon à activer le mode de veille, pendant une liaison radio active du module radio (9), en particulier une liaison radio active avec nécessité d'un débit de données élevé.

2. Appareil de chantier à deux conducteurs (3) conforme à la revendication 1,
**caractérisé en ce que**
l'unité de commande (5) et le module radio (9) sont reliés de sorte que soit signalée à l'unité de commande une liaison radio active du module radio (9) en particulier une liaison radio active avec nécessité d'un débit de données élevé.

3. Appareil de chantier à deux conducteurs (3) conforme à l'une des revendications 1 et 2,
**caractérisé en ce que**
le courant de mesure (I_{M}) est, compris dans la plage prédéfinie, entre 4 mA et 20 mA, et le courant de défaut est inférieur à 4 mA, en particulier égal à 3,6 mA et le courant de veille est supérieur à 20 mA et en particulier égal à 22 mA.

4. Appareil de chantier à deux conducteurs (3) conforme à l'une des revendications 1 à 3,
**caractérisé en ce que**
dans le mode de veille aucun signal analogique n'est transmis à l'unité prioritaire (15) et celle-ci fonctionne en tant que source d'énergie pure.

5. Appareil de chantier à deux conducteurs (3) conforme à l'une des revendications 1 à 4,
**caractérisé en ce que**
le capteur (7) et le module radio (9) sont reliés à l'unité de commande (5).

6. Procédé permettant de faire fonctionner un appareil de chantier à deux conducteurs (3) comprenant une unité de commande (5) et un capteur (7), l'appareil de chantier (3) pouvant être relié par l'intermédiaire d'une conduite à deux brins (13) à une unité prioritaire (15) et des signaux provenant de l'appareil de chantier (3) étant transmis à l'unité prioritaire (15) au moins sous la forme d'un courant indépendant de la charge (I_{M}) situé dans une plage prédéfinie, un courant de défaut (I_{F}) situé au-dessous de la plage prédéfinie, signalant un défaut et un courant de veille (I_{w}) situé au-dessus de la plage prédéfinie signalant un mode de veille dans lequel il n'y a pas de défaut, **caractérisé en ce que**
l'appareil à deux conducteurs comporte un module radio (9) et, lors d'une liaison radio active le courant de veille (I_{w}) alimente le module radio (9), pendant une liaison radio active du module radio (9) le mode de veille étant activé par l'unité de commande (5).

7. Procédé conforme à la revendication 6,
**caractérisé en ce qu'**
après la coupure d'une liaison radio active du module radio (9) le courant de veille (I_{w}) est désactivé, et, selon l'état de l'appareil de terrain (3) un courant de défaut (I_{F}) ou un courant de mesure (I_{M}) est activé.

8. Dispositif de mesure (1) comprenant :
- un appareil de chantier à deux conducteurs (3) conforme aux revendications 1 à 5, et
- une unité prioritaire (15) à laquelle est relié l'appareil de terrain (3) par une conduite à deux brins (13) .
